# EUROPÄISCHE PATENTSCHRIFT

(11) **EP 1 393 608 B1**
(45) Veröffentlichungstag und Bekanntmachung des Hinweises auf die Patenterteilung: **06.10.2004**
(21) Anmeldenummer: 02729911.4
(22) Anmeldetag: 24.05.2002
(51) Int. Cl.: H05K 13/04

(54) **BESTÜCKKOPF MIT EINEM SCHRITTWEISE VERDREHBAREN ROTOR UND EINER PNEUMATISCHEN DRUCKSTEUEREINRICHTUNG**
ASSEMBLY HEAD COMPRISING A STEPPED-DRIVE ROTATING ROTOR AND A PNEUMATIC PRESSURE CONTROL DEVICE
TETE DE MONTAGE COMPRENANT UN ROTOR A ROTATION PROGRESSIVE ET UN SYSTEME DE COMMANDE DE PRESSION PNEUMATIQUE

(30) Priorität: 07.06.2001 DE 10127735
(43) Veröffentlichungstag der Anmeldung: 03.03.2004
(73) Patentinhaber: SIEMENS AKTIENGESELLSCHAFT, 80333 München (DE)
(72) Erfinder: BURGER, Stefan, 81379 München (DE); DÜBEL, Rainer, 85598 Baldham (DE)
(86) Internationale Anmeldenummer: PCT/DE2002/001920
(87) Internationale Veröffentlichungsnummer: WO 2002/100146

(56) Entgegenhaltungen:
- EP-A- 0 906 010
- WO-A-96/01036
- WO-A-97/29620
- US-A- 6 102 365

## Beschreibung

Die Erfindung bezieht sich auf einen in einer Linearführung verfahrbaren Bestückkopf mit einem Stator und einem schrittweise verdrehbaren Rotor, der eine Mehrzahl von Pipetten zum Ansaugen von elektrischen Bauelementen aufweist, wobei die Pipetten jeweils an eine pneumatische Leitung angeschlossen sind, wobei jeweils eine der Pipetten in eine Aufsetz- bzw. Abholposition bewegbar ist und wobei die in dieser Position befindliche Pipette über ein Steuerventil mit einem Druckluftimpuls beaufschlagbar ist und mittels eines zirkulären Schiebers mit einer stationären Leitung verbindbar ist.

Ein solcher Bestückkopt ist aus US-A-6 102 365 bekannt.

Durch die EP 0 879 550 B1 ist es bekannt, das Steuerventil als mechanisch betätigtes Umschaltventil auszubilden, durch das die Pipette wahlweise mit Vakuum oder Druckluft verbunden werden kann. Dabei ist es üblich, für die verschiedenen Pipettentypen Schwellwerte des Vakuums abzuspeichern, um das Vorhandensein oder Fehlen eines Bauteils feststellen zu können. Pipetten für sehr kleine Bauelemente haben entsprechend kleine Saugöffnungen, bei denen die Druckdifferenz zwischen dem geöffneten und dem verchlossenen Saugkanal sehr gering ist. Bereits geringfügige Veränderungen des Umgebungsdrucks oder des Saugquerschnitts bei Verschmutzung führen zu Erkennungsfehlern, die sich in einer fehlerhaften Betriebsweise der Bestückvorrichtung niederschlagen.

Der Erfindung liegt die Aufgabe zugrunde, die Betriebssicherheit der Bestückvorrichtung zu erhöhen.

Diese Aufgabe wird durch die Erfindung gemäß Anspruch 1 gelöst. Durch die Überlagerungssteuerung ist es nun nicht mehr erforderlich, das Vakuum abzuschalten, so dass auf die einzelnen verschleißbehafteten Ventile verzichtet werden kann. Dabei wird lediglich dafür gesorgt, dass die zum Ventil führenden Kanäle außerhalb der Aufsetzposition durch den Schieber abgedichtet sind und lediglich in der Aufsetzposition mit dem Regelventil verbunden sind. Dabei kann durch die Leitungsgeometrie im Bereich der Verzweigung sowie durch die Steuerung des Druckimpulses dafür gesorgt werden, dass sich dieser nicht auf die Druckverhältnisse in den anderen Pipetten auswirkt.

Das von den anderen Pipetten durch den Schieber getrennte Steuerventil kann ein so starkes Vakuum erzeugen, daß beim Abholen des Bauelements ein maximaler Saugdruck sicher erreicht wird, unabhängig davon, ob das Vakuum in den anderen Pipetten zwischen höheren und niedrigerem Niveau bei voller oder geringer Belegung mit Bauelementen schwankt.

Vorteilhafte Weiterbildungen der Erfindung sind in Unteransprüchen gekennzeichnet:

Das Schaltventil nach Anspruch 2 stellt ein einfaches Bauteil dar, das insbesondere bei der Handhabung unkritischer Bauteile verwendet werden kann.

Durch das Regelventil nach den Ansprüchen 3 und 4 können die Drücke in der Steuerleitung genau auf die jeweils bestwirkenden Werte eingestellt werden.

Durch das Regelventil nach Anspruch 5 wird der Regelkreis innerhalb des Regelventils mit entsprechend kurzem Regelzyklus gebildet. Der Sensor und das Regelventil bilden eine integrierte Einheit mit definierten Leitungsverhältnissen und entsprechender Genauigkeit unter Wegfall eines zusätzlichen Sensors.

Die Strahlpumpe nach Anspruch 6 stellt ein einfaches, schnell und genau zu regelndes kompaktes Bauteil dar, wobei das als Rückstaudrossel dienende Stellglied durch den steuerbaren Antrieb z. B. mit Hilfe der Wegmesseinrichtung nach Anspruch 7 besonders rapide und genau in die vorgesehene Regelposition verstellt werden kann.

Durch die Weiterbildung nach Anspruch 8 wird in einfaches Weise das anliegende permanente Vakuum an jeder der Pipetten ohne dieses abzuschalten erzeugt und in sehr kurzer Umschaltzeit modifiziert bzw. überkompensiert, um im Moment des Aufsetzens einen zeitlich eng begrenzten Druckluftimpuls erzeugen zu können. Es ist aber auch möglich, das Saugleitungen der einzelnen Pipetten an eine leistungsstarke zentrale Vakuumleitung anzuschließen.

Im Folgenden wird die Erfindung anhand eines in der Zeichnung dargestellten Ausführungsbeispieles näher erläutert.
- Figur 1: zeigt schematisiert einen bekannten Bestückkopf,
- Figur 2: in ähnlicher Weise einen Bestückkopf nach der Erfindung in vergrößerter Darstellung.

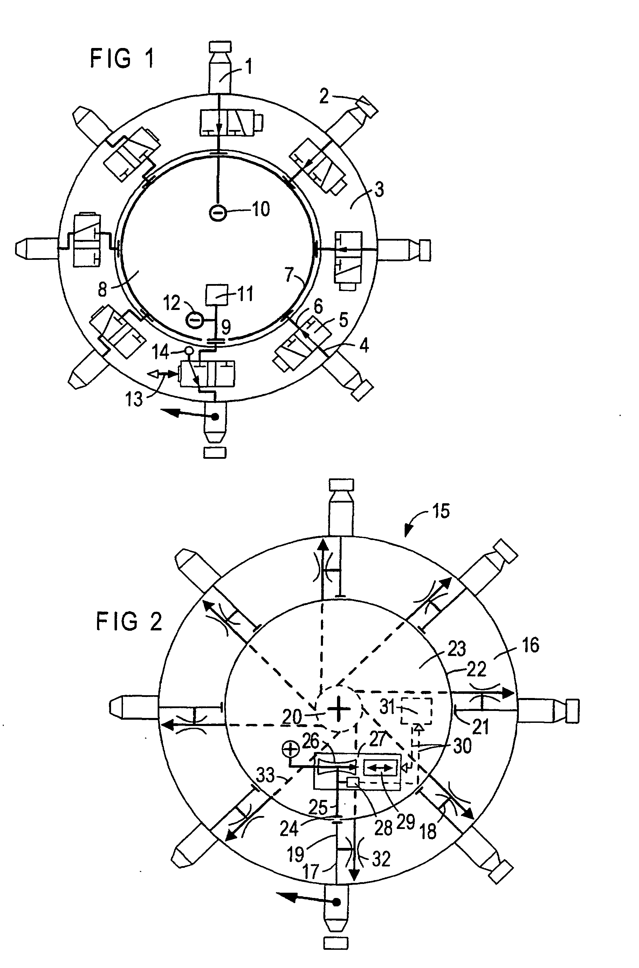

Nach Figur 1 weist ein revolverartiger Bestückkopf sternförmig abstehende Pipetten 1 zum Ansaugen von Bauelementen 2 auf. Die Pipetten sind an einem Rotor 3 gelagert und an je eine pneumatische Leitung 4 angeschlossen, die in ein Umschaltventil 5 mündet. Von diesen führen Saugleitungen 6 zu einem drehschieberartigen Verteiler 7.

Der Rotor 3 ist in der Richtung des Drehpfeiles schrittweise derart verdrehbar, dass jeweils eine der Pipetten 1 in eine Aufsetzposition gelangt, in der das Bauteil 2 auf eine Leiterplatte aufgesetzt bzw. aus einem Bauteilevorrat entnommen werden kann. Der Verteiler 7 befindet sich an der Schnittstelle zwischen dem Rotor 3 und einem Stator 8 und ist so gestaltet, dass jeweils die in der Aufsetzposition befindliche Saugleitung 6 temporär mit einer stationären Steuerleitung 9 verbunden ist. Die übrigen Saugleitungen 6 sind mit einer permanenten Vakuumquelle des Stators 8 verbunden. An die Steuerleitung 9 ist ein Drucksensor 11 angeschlossen, mit dem der Druck in der Saugleitung 6 überwacht werden kann.

Die Steuerleitung 9 endet in einem Schaltventil 12, über das sie schaltbar mit einer weiteren Vakuumquelle 10 verbunden werden kann. Die Umschaltventile 5 sind mittels eines stationären mechanischen Antriebs 13 betätigbar und verbleiben während des weiteren Umlaufes in der jeweils gewählten Schaltstellung. Vor dem Aufsetzen der Bauelemente 2 stehen die Umschaltventile auf Durchgang, so dass die Pipetten 1 an das permanente Vakuum angeschlossen sind. Das Schaltventil 12 ist während der Aufsetzphase ebenfalls auf Vakuum geschaltet, so dass auch die zugehörige Pipette 1 mit Vakuum versorgt ist.

Das in der Aufsetzstellung befindliche Umschaltventil 5 ist außerdem temporär mit einer Druckluftquelle 14 verbunden. Der mechanische Antrieb 13 schaltet nach dem Aufsetzen des Bauelements 2 auf die Leiterplatte das Umschaltventils 5 auf die Druckluftquelle 14, aus der ein kurzer Druckluftimpuls abgegeben wird, der das Bauelement 2 sicher von der Pipettenspitze ablöst. Das Umschaltventil 5 bleibt sodann in dieser Schaltstellung, in der die Pipette entlüftet und das Vakuum abgeschaltet ist.

Beim Abholen der Bauelemente 2 schaltet der Antrieb 13 das Umschaltventil 5 in die andere Stellung, in der die pneumatische Leitung 4 mit der am Vakuum liegenden Steuerleitung 9 verbunden ist. Dadurch wird das Bauelement 2 angesaugt. Da das Umschaltventil beim Weiterdrehen in den Haltekreis der Vakuumversorgung in dieser Schaltstellung verbleibt, bleibt auch die Pipette weiter unter Vakuum. Nach dem Ansaugen des Bauelements 2 an die in der Aufsetzposition befindliche Pipette 1 stärkt sich das Vakuum in der Steuerleitung 9 über einen vorgegebenen Schwellwert. Dieser Vorgang wird vom Drucksensor 11 detektiert und als korrekt bewertet. Wird hingegen die Vakuumschwelle nicht überschritten, so erkennt eine

Auswerte-Einrichtung das Bauteil als nicht korrekt aufgenommen. Da die Pipetten 1 mit ihren Saugöffnungen unterschiedlich großen Bauelementen angepasst sind, ergeben sich insbesondere bei kleinen Bauteilen geringe Druckunterschiede, die durch die Wirkung von Umwelteinflüssen überlagert werden können, so dass eine sichere Auswertung nicht möglich ist. Kann ein Bauteil nicht abgeholt werden oder wird es später verloren, so kann dieses Leck die Vakuumleistung der Vakuumquelle 10 verringern.

Nach Figur 2 ist ein erfindungsgemäß modifizierter Bestückkopf 15 ebenfalls mit den an einem Rotor 16 sternförmig abstehenden Pipetten 1 versehen. Die Pipetten 1 sind an jeweils eine pneumatische Leitung 17 angeschlossen, die sich in eine Saugleitung 18 und eine Steuerleitung 19 verzweigt. Sämtliche Saugleitungen 18 sind mit jeweils einer am Rotor befestigten mitlaufenden Strahlpumpe 32 verbunden, die über eine Verbindungsleitung permanent an eine zentrale Druckleitung 20 des Rotors 16 unmittelbar angeschlossen ist und in der Saugleitung ein permanentes Vakuum erzeugt.

Die Steuerleitungen 19 münden in je einer Öffnung 21 des Rotors 16, die durch einen zirkulären Schieber 22 eines Stators 23 verschlossen ist. Dieser weist an der unteren Aufsetzposition der Pipetten 1 eine einer zur Öffnung 21 komplementäre Schieberöffnung 24 auf, die über eine stationäre Steuerleitung 25 mit einer als Venturidüse ausgebildeten internen Strahlpumpe 26 eines Regelventils 27 des Stators 23 verbunden ist. Das Regelventil 27 weist einen an die stationäre Leitung 25 angeschlossen Sensor 28 zur Überwachung des Nutzdrucks in der Steuerleitung 25 bzw. 19 auf.

Die Ausströmöffnung der Strahlpumpe 26 ist durch ein mechanisch angetriebenes Stellglied 29 derart veränderbar, dass der Druck in der stationären Steuerleitung 25 feinstufig verändert werden kann. Der Sensor 28 und der mechanische Antrieb sind über elektrische Leitungen 30 mit einer elektronischen Steuerung 31 verbunden, in der den unterschiedlichen Pipettentypen und/oder Bauteiletypen zugeordnete Druckwerte gespeichert sind.

Beim Aufsetzen des Bauelements 2 auf eine Leiterplatte kann der Nutzdruck in der Steuerleitung 19 so stark erhöht werden, so dass er das Vakuum der Saugleitung 18 in der pneumatischen Leitung 17 überlagert, so dass ein in Stärke und Dauer geregelter Druckluftimpuls auf das Bauteil ausgegeben werden kann, um dieses sicher von der Pipette 1 abzulösen und auf die Leiterplatte aufzusetzen. Beim Aufnehmen eines Bauelements 2 aus einer Zuführeinrichtung kann der Saugdruck in der pneumatischen Leitung 17 mittels des Sensors 28 zu überwacht werden.

Die Verzweigungsgeometrie zwischen der Saugleitung 18 und der Steuerleitung 19 kann weitgehend neutralisierend gestaltet sein, so daß das Vakuum der Saugleitung 18 die Verhältnisse in der Steuerleitung 19 kaum beeinflußt und daß der kurze Druckimpuls der Steuerleitung 19 nur gering in Saugleitung 18 eingekoppelt wird.

## Patentansprüche

1. In einer Linearführung verfahrbarer Bestückkopf (15) mit einem Stator (23) und einem schrittweise verdrehbaren Rotor (16) , der eine Mehrzahl von Pipetten (1) zum Ansaugen von elektrischen Bauelementen (2) aufweist,
wobei die Pipetten (1) jeweils an eine pneumatische Leitung (17) angeschlossen sind,
wobei jeweils eine der Pipetten (1) in eine Aufsetz- bzw. Abholposition bewegbar ist und
wobei die in dieser Position befindliche Pipette (1) über ein Steuerventil (27), mit einem Druckluftimpuls beaufschlagbar ist und mittels eines zirkulären Schiebers (22) mit einer stationären Leitung (25) verbindbar ist,
**dadurch gekennzeichnet, daß** sich jede pneumatische Leitung (17) in eine permanent Vakuum führende Saugleitung (18) und in eine Steuerleitung (19) verzweigt, wobei die Steuerleitung (19) mit dem am Stator verankerten Steuerventil über die stationäre Leitung (25) verbindbar ist und
daß ein vom Steuerventil (27) ausgehender Druckimpuls derart einstellbar und in die jeweilige pneumatische Leitung (17) einleitbar ist, daß er das permanent anliegende Vakuum überlagert.

2. Bestückkopf nach Anspruch 1,
**dadurch gekennzeichnet, daß** das als Schaltventil ausgebildete Steuerventil an eine eigene Druckquelle und eine eigene Vakuumquelle angeschlossen ist.

3. Bestückkopf nach Anspruch 1 oder 2,
**dadurch gekennzeichnet, daß** das Steuerventil als Regelventil (27) ausgebildet ist, durch das der Nutzdruck insbesondere ein Überdruck in der Steuerleitung (19) feinstufig regelbar ist.

4. Bestückkopf nach Anspruch 3,
**dadurch gekennzeichnet, daß** sowohl der Über- als auch der Unterdruck in der Steuerleitung (19) regelbar ist.

5. Bestückkopf nach einem der vorhergehenden Ansprüche,
**dadurch gekennzeichnet, daß** das Regelventil (27) einen integrierten Sensor (28) zur Messung des Nutzdrucks aufweist und
daß der Sensor (28) zur Überwachung der pneumatischen Leitung (17) beim Aufnehmen und Abgeben des Bauelements (2) aktivierbar ist.

6. Bestückkopf nach Anspruch 3, 4 oder 5,
**dadurch gekennzeichnet, daß** Regelventil (27) eine Strahlpumpe mit einem in einer Ausströmöffnung mündenden Hauptstromkanal und einem von diesem abzweigenden Nebenstromkanal aufweist,
daß der Ausströmquerschnitt mittels einer stufenlos verstellbaren Stellglieds (29) veränderbar ist und
daß das Stellglied (29) mit einem steuerbaren mechanischen Antrieb verbunden ist.

7. Bestückkopf nach Anspruch 6,
**dadurch gekennzeichnet, daß** der Antrieb (29) eine Wegmesseinrichtung aufweist.

8. Bestückkopf nach einem der vorhergehenden Ansprüche,
**dadurch gekennzeichnet, daß** jede der Saugleitungen (17) an eine eigene am Rotor (16) angeordnete Strahlpumpe (32) angeschlossen ist, die über eine Verbindungsleitung (33) aus einer zentralen Druckleitung (20) des Rotors (16) gespeist ist.

## Claims

1. An insertion head (15) which is moveable in a linear guide, with a stator (23) and a stepwise rotatable rotor (16) which has a plurality of pipettes (1) for picking electrical components (2),
with the pipettes (1) being connected in each case to a pneumatic line (17),
with one of the pipettes (1) in each case being moved to a placing or picking position and
with the pipette (1) located in this position being pressurized via a control valve (27) by a compressed air pulse and being connectable by means of a circular slide valve (22) to a stationary line (25),
**characterized in that** each pneumatic line (17) branches into a suction line (18) with a permanent vacuum flow and into a control line (19), with the control line (19) being connectable to the control valve fixed to the stator by way of the stationary line (25) and
that a pressure pulse emitted from the control valve (27) can be adjusted and fed into the respective pneumatic line (17) in such a way that it overlays the permanently present vacuum.

2. Insertion head according to claim 1,
**characterized in that** the control valve embodied as a selector valve is connected to its own pressure source and its own vacuum source.

3. Insertion head according to claim 1 or 2,
**characterized in that** the control valve is embodied as a regulator valve (27) by means of which the working pressure, in particular an overpressure in the control line (19), can be regulated in fine increments.

4. Insertion head according to claim 3,
**characterized in that** both the overpressure and the underpressure in the control line (19) are controllable.

5. Insertion head according to one of the preceding claims,
**characterized in that** the regulator valve (27) has an integral sensor (28) for measuring the working pressure and
that the sensor (28) can be activated in order to monitor the pneumatic line (17) when picking and placing the component (2).

6. Insertion head according to claim 3, 4 or 5,
**characterized in that** the regulator valve (27) has a jet pump with a main flow channel terminating in an outlet flow opening and a secondary flow channel branching from this,
that the outlet flow cross-section can be changed by an infinitely variable actuating element (29) and
that the actuating element (29) is connected to a controllable mechanical drive.

7. Insertion head according to claim 6,
**characterized in that** the drive (29) has a path measuring device.

8. Insertion head according to one of the preceding claims,
**characterized in that** each of the suction lines (17) is connected to its own jet pump (32) arranged on the rotor (16), each said pump being fed via a connecting line (33) from a central pressure line (20) of the rotor (16).

## Revendications

1. Tête de revêtement (15) pouvant se déplacer dans un guide linéaire comprenant un stator (23) et un rotor (16) pouvant tourner progressivement et qui présente une pluralité de pipettes (1) pour aspirer des composants électriques (2) ,
dans laquelle les pipettes (1) sont raccordées à chaque fois à une conduite pneumatique (17),
dans laquelle une des pipettes (1) est déplaçable à chaque fois dans une position de placement resp. d'enlèvement et
dans laquelle une impulsion d'air comprimé peut être appliquée au moyen d'une soupape de commande (27) à la pipette (1) se trouvant dans cette position et qui peut être reliée à l'aide d'un curseur circulaire (22) à une conduite stationnaire (25),
**caractérisée en ce que** chaque conduite pneumatique (17) se ramifie en une conduite d'aspiration (18) conduisant en permanence au vide et en une conduite de commande (19), la conduite de commande (19) pouvant être reliée au moyen de la conduite stationnaire (25) à la soupape de commande ancrée sur le stator et **en ce qu'**une impulsion de pression partant de la soupape de commande (27) est réglable et peut conduire dans la conduite pneumatique respective (17) de telle sorte qu'elle masque le vide présent en permanence.

2. Tête de revêtement selon la revendication 1,
**caractérisée en ce que** la soupape de commande conçue comme soupape de commutation est raccordée à une source de pression propre et une source de vide propre.

3. Tête de revêtement selon la revendication 1 ou 2,
**caractérisée en ce que** la soupape de commande est conçue comme une soupape de réglage (27), par laquelle la pression utile, en particulier une surpression, peut être réglée à régulation sensible dans la conduite de commande (19).

4. Tête de revêtement selon la revendication 3,
**caractérisée en ce que** non seulement la surpression mais aussi la dépression dans la conduite de commande (19) est réglable.

5. Tête de revêtement selon l'une des revendications précédentes,
**caractérisée en ce que** la soupape de réglage (27) présente un détecteur intégré (28) pour mesurer la pression utile et **en ce que** le détecteur (28) peut être activé pour surveiller la conduite pneumatique (17) lors de la prise et de la dépose du composant (2).

6. Tête de revêtement selon la revendication 3, 4 ou 5,
**caractérisée en ce que** la soupape de réglage (27) présente une pompe à jet avec un canal de courant principal débouchant dans une ouverture de déversement et un canal de courant secondaire dérivant de celui-ci, et **en ce que** la section de déversement peut être modifiée au moyen d'un vérin (29) ajustable sans gradations et **en ce que** le vérin (29) est relié à un entraînement mécanique pouvant être commandé.

7. Tête de revêtement selon la revendication 6,
**caractérisée en ce que** l'entraînement (29) présente un dispositif de mesure de déplacement .

8. Tête de revêtement selon l'une des revendications précédentes,
**caractérisée en ce que** chacune des conduites d'aspiration (17) est raccordée à une pompe à jet propre disposée sur un rotor (16) et est alimentée par une conduite de liaison (33) à partir d'une conduite de pression centrale (20) du rotor (16).
